# FASCICULE DE BREVET EUROPEEN

(11) **EP 0 696 392 B1**
(45) Date de publication et mention de la délivrance du brevet: **22.07.1998**
(21) Numéro de dépôt: 95910596.6
(22) Date de dépôt: 24.02.1995
(51) Int. Cl.: H03G 3/00, H03G 3/20

(54) **PROCEDE ET DISPOSITIF DE CONTROLE AUTOMATIQUE DE GAIN DE CIRCUITS DE RECEPTION**
VERFAHREN UND VORRICHTUNG ZUR AUTOMATISCHER VERSTARKUNGSREGELUNG VON EMPFANGERSCHALTUNGEN
METHOD AND DEVICE FOR AUTOMATICALLY CONTROLLING GAIN IN RECEIVER CIRCUITS

(30) Priorité: 25.02.1994 FR 9402194
(43) Date de publication de la demande: 14.02.1996
(73) Titulaire: THOMSON multimedia, 92648 Boulogne Cédex (FR)
(72) Inventeur: HERGAULT, Stéphane, F-92402 Courbevoie Cédex (FR); HARDY, Patrick, F-92402 Courbevoie Cédex (FR)
(74) Mandataire: Ruellan-Lemonnier, Brigitte
(86) Numéro de dépôt international: FR9500221
(87) Numéro de publication internationale: WO9523454

(56) Documents cités:
- EP-A- 0 484 064
- FR-A- 2 408 943
- FR-A- 2 621 753

## Description

L'invention définie dans les revendications se rapporte au domaine de la réception de signaux et concerne un procédé et dispositif de contrôle automatique de gain de circuits de réception.

Elle concerne les signaux transmis par l'intermédiaire d'un canal de transmission affectant, d'une manière liée, la composante continue du signal transmis et le signal utile. C'est en particulier le cas dans le domaine des réseaux de vidéo communication utilisant la transmission par fibre optique.

Les procédés de contrôle automatique de gain de circuits de réception d'un équipement de transmission permettent de s'affranchir des pertes du canal de transmission en contrôlant le niveau du signal en sortie d'équipement. Le gain global du système peut alors être considéré comme constant. Ils sont habituellement basés sur une mesure du signal de sortie de ces circuits de réception pour agir sur une commande de gain d'un amplificateur composant ces circuits de façon à compenser les variations du signal dues aux pertes du canal de transmission. Il est ainsi possible de réaliser un asservissement de gain grâce à un signal d'erreur élaboré par comparaison de caractéristiques supposées stables dans le signal transmis, mesurables et reconnaissables dans le signal reçu, à une référence. Ces caractéristiques sont par exemple l'amplitude d'impulsions de synchronisation ou l'amplitude crête à crête du signal de transmission. Si le signal utile à transmettre ne possède pas de telles caractéristiques, celles-ci peuvent être ajoutées artificiellement au signal à l'émission. Ainsi peut être superposé au signal utile un signal de référence, par exemple un signal d'amplitude connue et dont la fréquence est en dehors des limites spectrales du signal utile, appelé signal pilote. Il peut également être envisagé, comme décrit dans la demande de brevet français FR-A-2 621 753 déposée par la Demanderesse, l'adjonction d'une composante continue constante et bien définie au signal à transmettre dans le cas où celui-ci en est dépourvu ou dans le cas où la composante continue d'origine n'est pas bien définie ou stable, celle-ci étant alors préalablement supprimée.

Cependant, les mesures de ces signaux de référence sont souvent délicates, l'extraction ou la mesure de leurs caractéristiques propres étant perturbée par le bruit de la liaison. La précision de l'asservissement de gain dépend de la qualité de transmission. Dans le cas d'une superposition d'un signal pilote dans les circuits d'émission, une amélioration du rapport signal sur bruit peut certes être obtenue en augmentant l'amplitude du signal pilote mais alors la dynamique utile du canal de transmission est réduite et les signaux parasites d'intermodulation augmentent également; une amélioration peut aussi être obtenue par affinage du filtrage dans les circuits de réception mais un problème de conception du filtre et de stabilité de la fréquence pilote apparaît alors. D'autre part, les circuits de réception dont le contrôle de gain est basé sur une mesure de niveau d'un signal transmis sont particulièrement sensibles au brouillage ou autres parasites qui désensibilisent ces récepteurs. Enfin, les signaux de référence, du fait de leurs caractéristiques, sont souvent en dehors de la bande passante des circuits de réception du signal utile; un asservissement en boucle fermée du gain de ces circuits à partir de ces signaux n'est alors pas réalisable.

La présente invention a pour objet un procédé de contrôle automatique de gain d'un récepteur de signaux transmis par l'intermédiaire d'un canal de transmission affectant, d'une manière liée, l'amplitude de la composante continue et celle du signal utile d'un signal transmis, caractérisé en ce qu'il consiste à moduler en amplitude par la composante continue du signal transmis, reçue par le récepteur, un signal pilote dont la fréquence est dans la bande passante de circuits d'amplification à commande de gain du récepteur mais en dehors du spectre de fréquence du signal utile transmis, à ajouter ce signal modulé au signal utile pour traverser ces circuits d'amplification, à démoduler en amplitude le signal pilote modulé extrait par filtrage en sortie des circuits d'amplification pour commander le gain de ces circuits

L'invention permet de réaliser un contrôle automatique de gain des circuits de réception en boucle fermée. Ces derniers peuvent être à liaison capacitive. La dynamique du canal de transmission exploitable par le signal utile n'est pas affectée par le procédé. Dans le cas où le signal transmis possède une composante continue, par exemple lors d'une transmission du signal par fibre optique, l'invention ne nécessite pas de modification des circuits d'émission, permettant par là même une compatibilité avec les émetteurs existants. Par l'utilisation de circuits de détection synchrone, elle permet une bonne précision d'asservissement et une très bonne réjection du bruit de la liaison. Une bonne protection est obtenue vis-à-vis du brouillage ou autres signaux parasites.

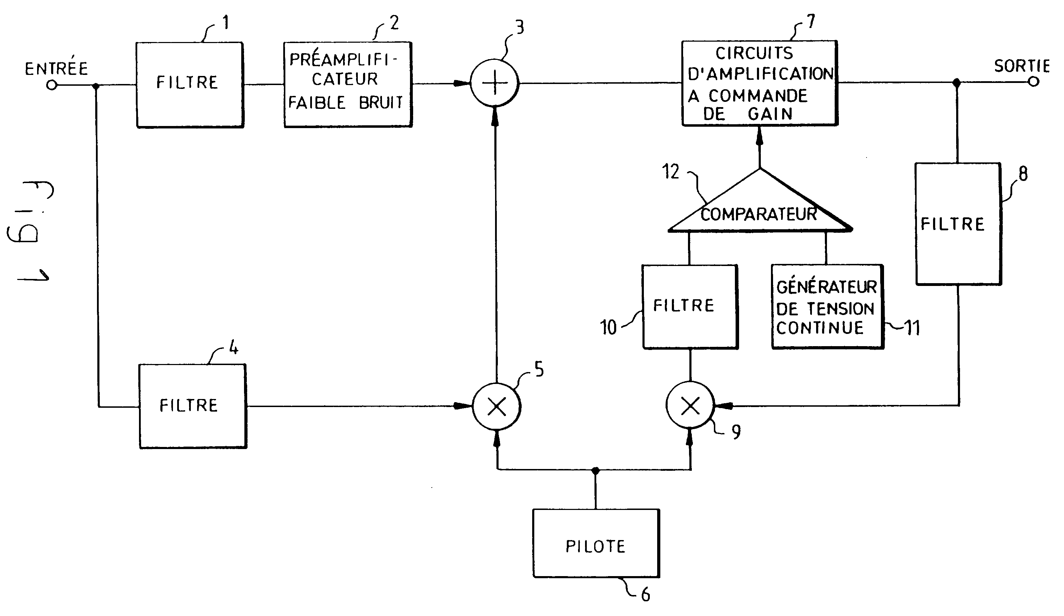

Les caractéristiques et avantages de la présente invention ressortiront mieux de la description suivante, donnée à titre d'exemple et en référence à la figure unique annexée qui représente un dispositif de contrôle automatique de gain d'un récepteur selon l'invention.

Le procédé selon l'invention est décrit ci-après à l'aide du schéma du dispositif représenté à la figure unique.

Ce dispositif de contrôle automatique de gain est intégré à des circuits de réception composant un récepteur. Le signal présent à l'entrée de ces circuits est un signal électrique comportant une composante continue et provenant d'un émetteur par l'intermédiaire d'un canal de transmission. C'est donc le courant détecté par la photodiode en entrée du récepteur dans le cas d'une transmission par fibre optique, c'est directement le signal en entrée du récepteur dans le cas d'une liaison coaxiale. Un premier filtre 1 de type passe-haut ou passe bande reçoit le signal électrique pour éliminer les signaux parasites en dehors des fréquences du signal utile et, en particulier, la composante continue du signal reçu.

Le signal filtré alimente ensuite un préamplificateur faible bruit 2 qui a pour rôle une préamplification de ce signal. La sortie du préamplificateur est reliée à une première entrée d'un additionneur 3.

Un deuxième filtre 4 en entrée des circuits de réception, de type passe-bas, reçoit également le signal électrique présent à l'entrée du filtre 1 pour ne transmettre que la composante continue de ce signal à une première entrée d'un multiplieur 5.La deuxième entrée de ce multiplieur 5 est alimentée par un signal pilote provenant d'un circuit générateur de signal pilote 6.

Le multiplieur 5 réalise une modulation d'amplitude du signal pilote par la composante continue présente sur la première entrée. Il inclut le filtrage nécessaire du signal modulé. La sortie de ce multiplieur est reliée à la deuxième entrée de l'additionneur 3 et la sortie de l'additionneur 3 est reliée à l'entrée de circuits d'amplification à commande de gain 7. Ainsi le signal à amplifier est composé du signal utile additionné du signal pilote modulé en amplitude. Tout se passe comme si ce signal pilote avait été additionné au signal utile dans les circuits d'émission, son atténuation correspondant à celle de la transmission caractérisée par l'atténuation de la composante continue du signal transmis. Deux conditions sont à respecter en ce qui concerne la fréquence du signal pilote : cette fréquence doit être choisie à l'intérieur de la bande passante des circuits d'amplification à commande de gain 7 mais doit être en dehors du spectre de fréquence du signal utile. Le signal pilote modulé est ainsi amplifié de la même manière que le signal utile et son extraction en sortie des circuits d'amplification 7 est réalisable. Pour ce faire, la sortie exploitée de ces circuits de réception, qui est la sortie des circuits d'amplification à commande de gain 7, est également transmise à un filtre présélecteur passe-bande 8, centré sur la fréquence du signal pilote, puis à une première entrée d'un multiplieur 9. La deuxième entrée du multiplieur 9 reçoit le signal pilote provenant du générateur de signal pilote 6. Le multiplieur 9 et le filtre 10, de type passe-bas, auquel est reliée la sortie du multiplieur 9 réalisent une démodulation d'amplitude.

La multiplication du signal modulé par un signal auxiliaire périodique de même fréquence que la porteuse du signal modulé et le filtrage du signal obtenu en sortie du multiplieur correspondent à une détection synchrone. Le signal obtenu en sortie du filtre 10 est l'enveloppe du signal modulé en amplitude. Il correspond à la composante continue du signal reçu par le récepteur Cette détection synchrone permet une amélioration du rapport signal sur bruit du signal détecté, donc une meilleure précision dans la mesure du signal. La bande passante de ce détecteur, déterminée par le filtre passe-bas 10 peut être très réduite et ainsi procurer une bonne réjection du bruit. Le signal détecté en sortie du filtre 10 est comparé à une tension de référence délivrée par un circuit générateur de tension continue 11, la comparaison étant effectuée par un comparateur 12 recevant le signal détecté sur une voie, la tension de référence sur l'autre voie. La sortie du comparateur, proportionnelle à l'écart de tension, est reliée à l'entrée de commande de gain des circuits d'amplification 7 pour commander l'amplification de ces derniers.

La boucle d'asservissement constituée par les circuits 8, 9, 10, 11, 12 permet ainsi de définir un gain d'amplification lié par exemple d'une manière inversement proportionnelle au niveau du signal continu reçu en entrée des circuits de réception.

Pour cette invention, il n'est pas nécessaire que l'atténuation de la composante continue du signal transmis soit identique à celle du signal utile. Il suffit qu'une relation lie ces deux atténuations dans toute la gamme d'atténuation pour, à partir de l'atténuation mesurée sur la composante continue en déduire celle du signal utile et corriger le gain en conséquence. Cette relation peut être une fonction mathématique ou définie par calibrage, la courbe de calibrage étant alors mémorisée dans une mémoire de correspondance. Un circuit spécifique dont la fonction de transfert traduit cette fonction mathématique ou foumissant les valeurs mémorisées de calibrage permet alors de transformer le signal détecté en sortie du filtre 10 en un signal à comparer, transmis à l'entrée du comparateur 12.

## Revendications

1. Procédé de contrôle automatique de gain d'un récepteur de signaux transmis par l'intermédiaire d'un canal de transmission affectant, d'une manière liée, l'amplitude de la composante continue et celle du signal utile d'un signal transmis, caractérisé en ce qu'il consiste à moduler en amplitude (5) par la composante continue du signal transmis, reçue par le récepteur, un signal pilote (6) dont la fréquence est dans la bande passante de circuits d'amplification à commande de gain du récepteur (7) mais en dehors du spectre de fréquence du signal utile transmis, à ajouter ce signal modulé au signal utile pour traverser ces circuits d'amplification (7), à démoduler en amplitude (9, 10) le signal pilote modulé extrait par filtrage (8) en sortie des circuits d'amplification (7) pour commander le gain de ces circuits (7).

2. Procédé selon la revendication 1, caractérisé en ce que la démodulation en amplitude (9, 10) du signal pilote modulé est une détection synchrone.

3. Procédé selon la revendication 2, caractérisé en ce que la détection synchrone (9, 10) utilise, pour signal de démodulation, le signal pilote (6) utilisé pour la modulation en amplitude (5).

4. Procédé selon l'une quelconque des revendications précédentes, caractérisé en ce que la tension détectée en sortie des circuits de démodulation d'amplitude est corrigée de l'écart d'atténuation dans la transmission entre le signal utile et la composante continue.

5. Dispositif de contrôle automatique de gain d'un récepteur de signaux transmis par l'intermédiaire d'un canal de transmission affectant, d'une manière liée, l'amplitude de la composante continue et celle du signal utile d'un signal transmis, caractérisé en ce qu'il comporte un générateur de signal pilote (6) dont la fréquence est dans la bande passante de circuits d'amplification à commande de gain du récepteur (7) mais en dehors du spectre des fréquences du signal utile transmis, un modulateur en amplitude (5) pour la modulation de ce signal pilote par un signal proportionnel à la composante continue du signal transmis, un additionneur (3) réalisant l'addition du signal pilote modulé au signal utile pour transmettre le signal résultant à l'entrée des circuits d'amplification (7), une boucle d'asservissement comprenant un filtre de sélection (8) du signal pilote modulé couplé à la sortie des circuits d'amplification (7) et un circuit de détection synchrone (9, 10) couplé au filtre pour commander le gain des circuits d'amplification (7).

6. Dispositif selon la revendication 5, caractérisé en ce que la boucle d'asservissement comporte un comparateur de tension (12) comparant la tension obtenue en sortie du circuit de détection synchrone (9, 10) à une tension de référence (11) pour commander le gain des circuits d'amplification (7).

7. Dispositif selon la revendication 5 ou 6, caractérisé en ce que la sortie des circuits de détection synchrone est couplée à un circuit de correction de niveau pour commander le gain des circuits d'amplification (7).

8. Dispositif selon la revendication 7, caractérisé en ce que le circuit de correction de niveau a une fonction de transfert calculée à partir de la relation liant l'amplitude du signal utile à celle de la composante continue.

9. Dispositif selon la revendication 7, caractérisé en ce que le circuit de correction de niveau comporte des circuits de mémoire dont le contenu est obtenu par calibrage de l'atténuation du signal utile à partir du niveau de la composante continue reçue.

10. Dispositif selon l'une des revendications 5 à 9, caractérisé en ce que le canal de transmission est une fibre optique.

## Patentansprüche

1. Verfahren zur automatischen Verstärkungsregelung eines Empfängers für Signale, die über einen Übertragungskanal übertragen werden, der gleichermaßen die Amplitude der Gleichspannungskomponente und die eines übertragenen Nutzsignals beeinflußt, gekennzeichnet durch die folgenden Schritte : ein Pilotsignal (6) wird durch die Gleichspannungskomponente des übertragenen, durch den Empfänger empfangenen Signals in der Amplitude moduliert (5), wobei die Frequenz des Pilotsignals (6) innerhalb der Durchlaßbandbreite der Verstärkerschaltungen (7) mit regelbarer Verstärkung des Empfängers, aber außerhalb des Frequenzspektrums des übertragenen Nutzsignals liegt,
das modulierte Signal wird dem Nutzsignal hinzugefügt und durchläuft die Verstärkerschaltungen (7), das durch Sieben (8) am Ausgang der Verstärkerschaltungen (7) extrahierte modulierte Pilotsignal wird amplitudendemoduliert (9, 10), um die Verstärkung dieser Schaltungen (7) zu regeln.

2. Verfahren nach Anspruch 1, dadurch gekennzeichnet, daß die Amplitudendemodulation (9, 10) des modulierten Pilotsignals eine Synchrongleichrichtung ist.

3. Verfahren nach Anspruch 2, dadurch gekennzeichnet, daß die Synchrongleichrichtung (9, 10) als Demodulationssignal das für die Amplitudenmodulation (5) dienende Pilotsignal (6) verwendet.

4. Verfahren nach einem der vorangehenden Ansprüche, dadurch gekennzeichnet, daß die am Ausgang der Schaltungen für die Amplitudendemodulation detektierte Spannung durch die Dämpfungsabweichung in der Übertragung zwischen dem Nutzsignal und der Gleichspannungskomponente korrigiert wird.

5. Vorrichtung zur automatischen Verstärkungsregelung eines Empfängers für Signale, die über einen Übertragungskanal übertragen werden, der gleichermaßen die Amplitude der Gleichspannungskomponente und die des übertragenen Nutzsignal beeinflußt, gekennzeichnet durch einen Pilotsignalgenerator (6), dessen Frequenz innerhalb der Durchlaßbandbreite der Verstärkerschaltungen (7) mit regelbarer Verstärkung des Empfängers, aber außerhalb des Frequenzspektrums des übertragenen Nutzsignals liegt, einen Amplitudenmodulator (5) zur Modulation des Pilotsignals durch ein Signal, das einer Gleichspannungskomponente des übertragenen Signals proportional ist, eine Addierstufe (3) zum Hinzufügen des modulierten Pilotsignals zu dem Nutzsignal und zum Zuführen des daraus resultierenden Signals zu dem Eingang der Verstärkerschaltungen (7), eine Regelschleife mit einem Selektionsfilter (8) für das modulierte Pilotsignal, das mit dem Ausgang der Verstärkerschaltungen (7) verbunden ist, und eine Schaltung (9, 10) zur Synchrongleichrichtung, die mit dem Filter zur Verstärkungsregelung der Verstärkerschaltungen (7) verbunden ist.

6. Vorrichtung nach Anspruch 5, dadurch gekennzeichnet, daß die Regelschleife einen Spannungskomparator (12) enthält, der die am Ausgang der Schaltung (9, 10) zur Synchrongleichrichtung gewonnene Spannung mit einer Referenzspannung (11) vergleicht, um die Verstärkung der Verstärkerschaltungen (7) zu regeln.

7. Vorrichtung nach Anspruch 5 oder 6, dadurch gekennzeichnet, daß der Ausgang der Schaltungen für die Synchrongleichrichtung mit einer Schaltung zur Korrektur des Pegels für die Steuerung der Verstärkung der Verstärkerschaltungen (7) verbunden ist.

8. Vorrichtung nach Anspruch 7, dadurch gekennzeichnet, daß die Pegel-Korrekturschaltung eine Übertragungsfunktion aufweist, die aus dem Verhaltinis zwischen der Amplitude des Nutzsignals und der der Gleichspannungskomponente berechnet ist.

9. Vorrichtung nach Anspruch 7, dadurch gekennzeichnet, daß die Pegel-Korrekturschaltung Speicherschaltungen enthält, deren Inhalt durch Auswertung der Dämpfung des Nutzsignals aus dem Pegel der empfangenen Gleichspannungskomponente gewonnen ist.

10. Vorrichtung nach einem der Ansprüche 5 bis 9, dadurch gekennzeichnet, daß der Übertragungskanal eine Lichtleiffaser ist.

## Claims

1. Method for the automatic gain control of a receiver of signals transmitted by means of a transmission channel affecting, in a related fashion, the amplitude of the continuous component and that of the useful signal of a transmitted signal, characterised in that it consists of amplitude modulating (5), by means of the continuous component of the transmitted signal, received by the receiver, a pilot signal (6) whose frequency is in the passband of amplification circuits with gain control of the receiver (7), but outside the frequency spectrum of the useful signal transmitted, adding this modulated signal to the useful signal in order to pass through these amplification circuits (7), amplitude demodulating (9, 10) the modulated pilot signal extracted by filtering (8) at the output of the amplification circuits (7) in order to control the gain of these circuits (7).

2. Method according to Claim 1, characterised in that the amplitude demodulation (9, 10) of the modulated pilot signal is a synchronous detection.

3. Method according to Claim 2, characterised in that the synchronous detection (9, 10) uses, for a demodulation signal, the pilot signal (6) used for the amplitude modulation (5).

4. Method according to any one of the preceding claims, characterised in that the voltage detected at the output of the amplitude demodulation circuits is corrected for the difference in attenuation in the transmission between the useful signal and the continuous component.

5. Device for the automatic gain control of a receiver for signals transmitted by means of a transmission channel affecting, in a related fashion, the amplitude of the continuous component and that of the useful signal of a transmitted signal, characterised in that it includes a generator of a pilot signal (6) whose frequency is in the passband of amplification circuits with gain control of the receiver (7) but outside the frequency spectrum of the useful signal transmitted, an amplitude modulator (5) for modulating this pilot signal by a signal proportional to the continuous component of the transmitted signal, an adder (3) performing the addition of the modulated pilot signal to the useful signal in order to transmit the resulting signal to the input of the amplification circuits (7), a control loop comprising a selection filter (8) for the modulated pilot signal coupled to the output of the amplification circuits (7), and a synchronous detection circuit (9, 10) coupled to the filter in order to control the gain of the amplification circuits (7).

6. Device according to Claim 5, characterised in that the control loop includes a voltage comparator (12) comparing the voltage obtained at the output of the synchronous detection circuit (9, 10) with a reference voltage (11) in order to control the gain of the amplification circuits (7).

7. Device according to Claim 5 or 6, characterised in that the output of the synchronous detection circuits is coupled to a level correction circuit in orde to control the gain of the amplification circuits (7).

8. Device according to Claim 7, characterised in that the level correction circuit has a transfer function calculated from the relationship relating the amplitude of the useful signal to that of the continuous component.

9. Device according to Claim 7, characterised in that the level correction circuit includes memory circuits whose content is obtained by calibrating the attenuation of the useful signal from the level of the continuous component received.

10. Device according to one of Claims 5 to 9, characterised in that the transmission channel is an optical fibre.
